# EUROPEAN PATENT APPLICATION

(11) **EP 4 683 464 A1**
(43) Date of publication of application: **21.01.2026**
(21) Application number: 25152436.9
(22) Date of filing: 17.01.2025
(51) Int. Cl.: H10F 71/00, H10F 77/20

(54) **METAL-SEMICONDUCTOR CONTACT STRUCTURE, SOLAR CELL AND PHOTOVOLTAIC MODULE**

(30) Priority: 15.07.2024 CN 202410941983
(71) Applicant: Tongwei Solar (Chengdu) Co., Ltd., Chengdu, Sichuan 610299 (CN)
(72) Inventor: LIAO, Wenxin, Chengdu (CN); CHEN, Yang, Chengdu (CN); YU, Bin, Chengdu (CN); MENG, Xiajie, Chengdu (CN)
(74) Representative: Ran, Handong

(57) **Abstract**

The present application relates to the field of solar cells, and in particular to a metal-semiconductor contact structure, a solar cell and a photovoltaic module. The metal-semiconductor contact structure includes: a doped semiconductor layer; a metal electrode in contact with the doped semiconductor layer; a first conductive region provided at a contact interface between the doped semiconductor layer and the metal electrode, wherein the first conductive region has: a first conductive structure, the first conductive structure including a plurality of first metal particles distributed in the first conductive region, the first metal particles having a spherical and/or ellipsoidal shape, at least part of the first conductive structure contacting the doped semiconductor layer; and a second conductive structure, wherein the second conductive structure is radial, at least part of the second conductive structure is located on a surface of the first metal particles, and a radial direction of the second conductive structure is a direction towards the metal electrode; wherein the metal electrode, the first metal particles, and the second conductive structure all have a same metal element. The metal-semiconductor contact structure can improve the carrier transport ability, and improve the photoelectric conversion efficiency of the solar cell.

## Description

### TECHNICAL FIELD

The present application relates to the field of solar cells, and in particular to a metal-semiconductor contact structure, a solar cell and a photovoltaic module.

### BACKGROUND

In a solar cell, the contact performance between a metal electrode and a doped semiconductor layer has a significant impact on the photovoltaic conversion efficiency and other electrical performance indicators of the solar cell. The contact position between the metal electrode and the doped semiconductor layer often leads to obvious carrier recombination phenomenon, more current loss, and limiting further improvement of the photoelectric conversion efficiency and other electrical properties of the solar cell.

### SUMMARY

In order to solve the above-mentioned technical problem, the present application discloses a metal-semiconductor contact structure, including:
a doped semiconductor layer;
a metal electrode in contact with the doped semiconductor layer;
a first conductive region provided at a contact interface between the doped semiconductor layer and the metal electrode, wherein the first conductive region has:
a first conductive structure, the first conductive structure including a plurality of first metal particles distributed in the first conductive region, the first metal particles having a spherical and/or ellipsoidal shape, at least part of the first conductive structure contacting the doped semiconductor layer;
a second conductive structure, wherein the second conductive structure is radial, at least part of the second conductive structure is located on a surface of the first metal particles, and a radial direction of the second conductive structure is a direction towards the metal electrode;
wherein the metal electrode, the first metal particles, and the second conductive structure all have a same metal element.

Further, a number ratio of the second conductive structure to the first metal particles is 1: 4000 to 1: 1.

Further, the number ratio of the second conductive structure to the first metal particles is 1: 1000 to 1: 20.

Further, a particle size of the first metal particles is 20 nm to 360 nm.

Further, in any 10 µm × 10 µm region of the first conductive region, the number of the first metal particles is 200 to 4000, wherein the number of the first metal particles having a particle size in a range of 100 nm to 360 nm is 100 to 1500, and the number of the first metal particles having a particle size in a range of less than 100 nm is 100 to 2500.

Further, the first conductive structure further includes second metal particles attached to a surface of the first metal particles, the first metal particles having a particle size of 20 nm to 360 nm, the second metal particles having a particle size of less than 20 nm, the number of the second metal particles on one of the first metal particles being 1 to 50, and the second metal particles having a same metal element as the first metal particles.

Further, a size of the second conductive structure is 0.2 µm to 2 µm.

Further, in any 10 µm × 10 µm region of the first conductive region, the number of the second conductive structure is 1 to 450, wherein the number of the second conductive structure having a particle size in a range of 1 µm to 2 µm is 1 to 100, and the number of the second conductive structure having a particle size in a range of less than 1 µm is 1 to 350.

Further, the second conductive structure includes a plurality of stripe-shaped first sub-structures diverging towards the metal electrode, and the number of the first sub-structures is 2 to 20.

Further, any one of the first sub-structures is composed of a plurality of second sub-structures, any one of the second sub-structures is in a shape of wheat grain, and a plurality of the second sub-structures are combined together to form the first sub-structure in a shape of wheat ears;
wherein the second sub-structure has a cross-sectional dimension of 2 nm to 40 nm.

Further, a second conductive region is further provided at a contact interface between the doped semiconductor layer and the metal electrode, the second conductive region is located at an edge of the first conductive region, and the second conductive region includes an unburned passivation layer, and the first conductive structure and/or the second conductive structure are provided between the unburned passivation layer and the metal electrode;
when the second conductive region includes the first conductive structure, a density of the first conductive structure in the second conductive region is lower than a density of the first conductive structure in the first conductive region; when the second conductive region includes the second conductive structure, a density of the second conductive structure in the second conductive region is lower than a density of the second conductive structure in the first conductive region.

Further, the doped semiconductor layer includes one of a doped amorphous silicon layer, a doped polycrystalline silicon layer, a doped microcrystalline silicon layer or a doped crystalline silicon layer; and/or,
a doping element in the doped semiconductor layer is an N-type conductive element or a P-type conductive element; and/or,
the metal element includes silver element; and/or,
at least a portion of the second conductive structure is located on a surface facing the metal electrode of the doped semiconductor layer.

In a second aspect, the present application provides a solar cell, including:
a silicon substrate;
a doped semiconductor layer, wherein the doped semiconductor layer is provided on the silicon substrate;
a metal electrode in contact with the doped semiconductor layer;
a first conductive region provided at a contact interface between the doped semiconductor layer and the metal electrode, wherein the first conductive region has:
a first conductive structure, the first conductive structure including a plurality of first metal particles distributed in the first conductive region, the first metal particles having a spherical and/or ellipsoidal shape, at least a portion of the first conductive structure contacting the doped semiconductor layer;
a second conductive structure, wherein the second conductive structure is radial, at least a portion of the second conductive structure is located on a surface of the first metal particles, and a radial direction of the second conductive structure is a direction towards the metal electrode;
wherein the metal electrode, the first metal particles, and the second conductive structure all have a same metal element.

Further, a number ratio of the second conductive structure to the first metal particles is 1: 4000 to 1: 1.

Further, the number ratio of the second conductive structure to the first metal particles is 1: 1000 to 1: 20.

Further, a particle size of the first metal particles is 20 nm to 360 nm.

Further, in any 10 µm × 10 µm region of the first conductive region, the number of the first metal particles is 200 to 4000, wherein the number of the first metal particles having a particle size in a range of 100 nm to 360 nm is 100 to 1500, and the number of the first metal particles having a particle size in a range of less than 100 nm is 100 to 2500.

Further, the first conductive structure further includes second metal particles attached to a surface of the first metal particles, the first metal particles having a particle size of 20 nm to 360 nm, the second metal particles having a particle size of less than 20 nm, the number of the second metal particles on one of the first metal particles being 1 to 50, and the second metal particles having the same metal element as the first metal particles.

Further, a size of the second conductive structure is 0.2 µm to 2 µm.

Further, in any 10 µm × 10 µm region of the first conductive region, the number of the second conductive structure is 1 to 450, wherein the number of the second conductive structure having a particle size in a range of 1 µm to 2 µm is 1 to 100, and the number of the second conductive structure having a particle size in a range of less than 1 µm is 1 to 350.

Further, the second conductive structure includes a plurality of stripe-shaped first sub-structures diverging towards the metal electrode, and the number of the first sub-structures is 2 to 20.

Further, any one of the first sub-structures is composed of a plurality of second sub-structures, any one of the second sub-structures is in a shape of wheat grain, and a plurality of the second sub-structures are combined together to form the first sub-structure in a shape of wheat ears; wherein the second sub-structure has a cross-sectional dimension of 2 nm to 40 nm.

Further, a second conductive region is further provided at a contact interface between the doped semiconductor layer and the metal electrode, the second conductive region is located at an edge of the first conductive region, and the second conductive region includes an unburned passivation layer, the first conductive structure and/or the second conductive structure is provided between the unburned passivation layer and the metal electrode; when the second conductive region includes the first conductive structure, a density of the first conductive structure in the second conductive region is lower than a density of the first conductive structure in the first conductive region; when the second conductive region includes the second conductive structure, a density of the second conductive structure in the second conductive region is lower than a density of the second conductive structure in the first conductive region.

Further, the solar cell further includes a dielectric layer provided between the silicon substrate and the doped semiconductor layer.

Further, the solar cell further includes a passivation layer provided on a side of the doped semiconductor layer facing away from the silicon substrate.

Further, the doped semiconductor layer includes an N-type doped semiconductor layer and a P-type doped semiconductor layer, the N-type doped semiconductor layer and the P-type doped semiconductor layer are arranged in an interdigitated arrangement on a backlight surface of the silicon substrate, and an isolation region is provided between the N-type doped semiconductor layer and the P-type doped semiconductor layer; and
the metal electrode includes a first metal electrode and a second metal electrode, the first metal electrode and the N-doped semiconductor layer being in contact with each other, and the second metal electrode and the P-doped semiconductor layer being in contact with each other.

In a third aspect, the present application provides a photovoltaic module, wherein the photovoltaic module includes the solar cell according to the second aspect, several of the solar cells being connected in series and/or in parallel to obtain a solar cell string; and
a packaging structure, wherein the solar cell string is packaged in the packaging structure.

Compared with the prior art, the present application has at least the following beneficial effects:
The metal-semiconductor contact structure provided in the embodiments of the present application has the advantages of rich types of carrier transport structures and a large number of carrier transport paths, and therefore can improve the carrier transport ability of the metal-semiconductor contact structure, improve the contact performance between the doped semiconductor layer and the metal electrode, and improve the photoelectric conversion efficiency of the solar cell.

### BRIEF DESCRIPTION OF THE DRAWINGS

To describe the technical solutions in embodiments of the present application more clearly, the following briefly describes the accompanying drawings for the embodiments. It is clear that the accompanying drawings in the following description show merely some embodiments of the present application, and a person of ordinary skill in the art may derive other drawings from these accompanying drawings without creative efforts.
FIG. 1 is a schematic structural diagram of a first solar cell according to an embodiment of the present application;
FIG. 2 is an enlarged schematic view of a structure at A in FIG. 1;
FIG. 3 is a schematic view showing a size measurement method of first metal particles according to an embodiment of the present application;
FIG. 4 is a schematic view showing a size measurement method of second metal particles according to an embodiment of the present application;
FIG. 5 is a schematic structural diagram of a second conductive structure according to an embodiment of the present application;
FIG. 6 is an enlarged schematic view of a structure at B in FIG. 2;
FIG. 7 is a schematic structural diagram of a second solar cell according to an embodiment of the present application;
FIG. 8 is an SEM diagram at the metal-semiconductor contact structure in a solar cell according to an embodiment of the present application.

### Description of the reference numerals:

100, Silicon substrate; 200, Doped semiconductor layer; 201, First doped semiconductor layer; 202, Second doped semiconductor layer; 300, Metal electrode; 301, First metal electrode; 302, Second metal electrode; 400, Passivation layer; 401, First passivation layer ; 402, Second passivation layer; 403, Third passivation layer; 500, Dielectric layer; 501, First dielectric layer; 502, Second dielectric layer; 600, P-type diffusion layer; 700, Passivating anti-reflection layer; 800, Light-receiving surface metal electrode; 1, Metal-semiconductor contact structure; 1a, First conductive region; 111, First metal particle; 112, Second metal particle; 12, Second conductive region; 121, First sub-structure; 1211, Second sub-structure; 1b. Second conductive region.

### DETAILED DESCRIPTION

The following clearly describes the technical solutions in embodiments of the present application with reference to the accompanying drawings in embodiments of this application. It is clear that the described embodiments are some but not all of embodiments of the present application. All other embodiments obtained by a person of ordinary skill in the art based on embodiments of the present application without creative efforts shall fall within the protection scope of this application.

In the present application, the orientation or positional relationship indicated by the terms "on", "under", "left", "right", "front", "back", "top", "bottom", "inside", "outside", "middle", "vertical", "horizontal", "transverse", "longitudinal" and the like is based on the orientation or positional relationship shown in the drawings. These terms are mainly intended to better describe the present application and its embodiments and are not intended to limit that the indicated devices, elements or constituents must have a particular orientation, or be constructed and operated in a particular orientation.

Also, in addition to being used to represent an orientation or positional relationship, some of the above terms may also be used to indicate other meanings. For example, the term "on" may also be used in some cases to denote a certain attachment or connection. The specific meanings of these terms in the present application may be understood by those ordinarily skilled in the art as the case may be.

In addition, the terms "installation", "setting", "being provided with", "connecting", "connected", "sleeving" should be understood broadly. For example, the connection may be a fixed connection, a detachable connection or an integrated construction, or may be a mechanical connection or an electrical connection, or may be a direct connection, or may be an indirect connection through an intermediary, or an internal communication between two devices, elements or constituents. The specific meanings of these terms in the present application may be understood by those ordinarily skilled in the art as the case may be.

In addition, the terms "first", "second", etc., are used primarily to distinguish different devices, elements or components (the specific type and construction may be the same or different) and are not used to indicate or imply the relative importance or quantity of the indicated device, element or component. Unless otherwise stated, "plurality" means two or more.

In a solar cell, carriers need to be transported to a metal electrode through a doped semiconductor layer, so the contact performance between the doped semiconductor layer and the metal electrode has a very important influence on the photoelectric conversion efficiency and other properties of the solar cell.

However, the contact position between the doped semiconductor layer and the metal electrode often leads to large-area interface damage due to the deep ablation of the metal electrode paste, which in turn makes the recombination loss between the doped semiconductor layer and the metal electrode serious, which is ultimately reflected in the fact that it is difficult to further improve the photoelectric conversion efficiency and other properties of the solar cell. It can be seen that it is necessary to continuously optimize the contact performance between the doped semiconductor layer and the metal electrode to improve the contact performance between the two and promote the further improvement of the photoelectric conversion efficiency of the solar cell.

In order to solve the above technical problems, embodiments of the present application provide a metal-semiconductor contact structure, a solar cell, and a photovoltaic module, and solve the above problems by optimizing a contact performance of the metal-semiconductor contact structure and improving conductivity thereof. Since the metal-semiconductor contact structure of the embodiments of the present application is applied to a solar cell (especially to a crystalline silicon solar cell), the metal-semiconductor contact structure therefor will be introduced below when the solar cell of the embodiments of the present application is introduced, and the metal-semiconductor contact structure therefor will not be described separately.

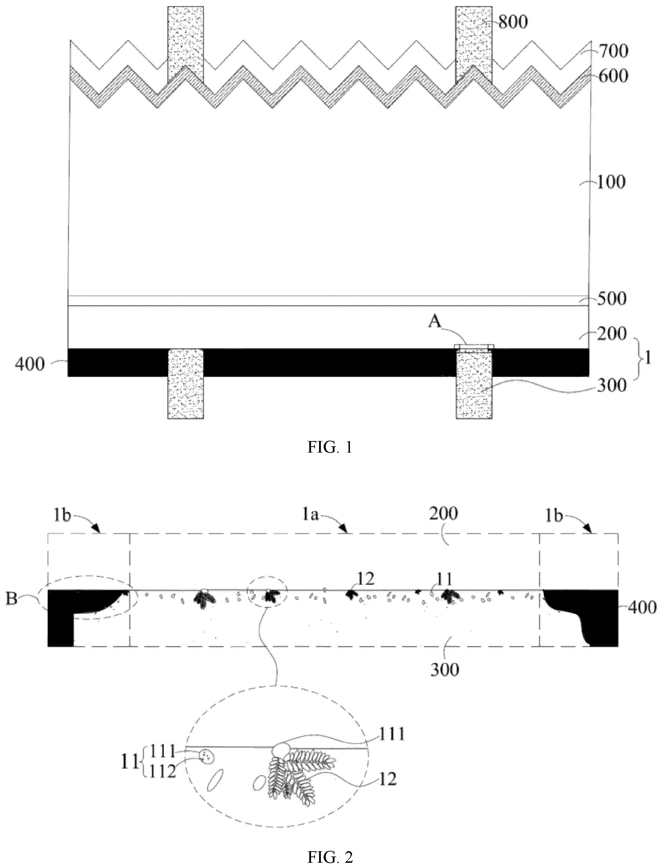

The embodiments of the present application provide a solar cell having a metal-semiconductor contact structure 1. Referring to FIG. 1 and FIG. 2, FIG. 1 is a schematic structural diagram of a first solar cell according to an embodiment of the present application, FIG. 2 is an enlarged schematic view of a structure at A in FIG. 1, and the solar cell includes:
a silicon substrate 100;
a doped semiconductor layer 200, wherein the doped semiconductor layer 200 is provided on the silicon substrate 100;
a metal electrode 300 in contact with the doped semiconductor layer 200;

That is, mutual contact between the doped semiconductor layer 200 and the metal electrode 300 forms the metal-semiconductor contact structure 1, and the mutual contact between the doped semiconductor layer 200 and the metal electrode 300 is physical contact, that is, the doped semiconductor layer 200 and the metal electrode 300 are in direct contact.

As shown in FIG. 2, in this metal-semiconductor contact structure 1, a first conductive region is provided at a contact interface between the doped semiconductor layer 200 and the metal electrode 300, wherein the first conductive region 1a has:
a first conductive structure 11, the first conductive structure 11 including a plurality of first metal particles 111 distributed in the first conductive region 1a, the first metal particles 111 having a spherical and/or ellipsoidal shape, at least a portion of the first conductive structure 11 contacting the doped semiconductor layer 200;
a second conductive structure 12, wherein the second conductive structure 12 is radial, at least a portion of the second conductive structure 12 is located on a surface of the first metal particles 111, and a radial direction of the second conductive structure 12 is a direction towards the metal electrode 300;
wherein the metal electrode 300, the first metal particles 111, and the second conductive structure 12 all have a same metal element.

For example, when the metal electrode 300 is a silver electrode, the first metal particles 111 are silver particles, and the second conductive structure 12 having a radial shape also includes a silver element, and specifically, the second conductive structure 12 having a radial shape may be formed by crystallization of silver ions after an electrochemical oxidation-reduction reaction.

The metal-semiconductor contact structure 1 provided in the embodiments of the present application has the advantages of rich types of carrier transport structures and a large number of carrier transport paths, and therefore can improve the carrier transport ability of the metal-semiconductor contact structure 1, improve the contact performance between the doped semiconductor layer 200 and the metal electrode 300, and improve the photoelectric conversion efficiency of the solar cell.

In the embodiments of the present application, both the radial second conductive structure 12 and the spherical and/or ellipsoidal first metal particles 111 have carrier transport capability, and more importantly, since at least a portion of the second conductive structure 12 is located on the surface of the first metal particles 111, the combination of the second conductive structure 12 and the first metal particles 111 may also be regarded as another carrier transport structure. Therefore, there are many types of structures capable of transporting carriers in the embodiments of the present application, which is advantageous for improving the carrier transport capability.

On this basis, the above-described structures can provide a plurality of different carrier transport paths, and help carriers to transport from the doped semiconductor layer 200 to the metal electrode 300 more smoothly and with less obstruction.

The first carrier transport path includes the silicon substrate 100, the doped semiconductor layer 200, the first metal particles 111, the radial second conductive structure 12, and the metal electrode 300. The photogenerated carriers generated in the silicon substrate 100 are transported into the doped semiconductor layer 200, then transported by the first metal particles 111 directly in contact with the doped semiconductor layer 200, and then transported to the metal electrode 300 by the radial second conductive structure 12 directly in contact with the first metal particles 111. Among them, the first metal particles 111 and the second conductive structure 12 are both metal and thus have good conductivity. In particular, since the second conductive structure 12 is radial and the radial divergence direction are the direction towards the metal electrode 300, this divergence structure feature makes the carrier transport paths longer and more, and the resistance is smaller, so that the carrier transport capacity may be more effectively improved.

Wherein, a second carrier transport path includes the silicon substrate 100, the doped semiconductor layer 200, the radial second conductive structure 12, and the metal electrode 300. Except the portion of the radial second conductive structure 12 located on the surface of the first metal particles 111, another portion of the radial second conductive structure 12 is directly grown on the surface of the doped semiconductor layer 200 facing the metal electrode 300, this portion of the second conductive structure 12 may directly transport carriers from the doped semiconductor layer 200 to the metal electrode 300. In addition, the metal-semiconductor contact structure 1 according to the embodiments of the present application further has a third carrier transport path, including the silicon substrate 100, the first metal particles 111 dispersed in the first conductive region 1a, and the metal electrode 300. Although at least some of the first metal particles 111 are not in direct contact with each other, the carriers can conduct electricity through these first metal particles 111 by using an electron tunneling effect.

In summary, it can be seen that the metal-semiconductor contact structure 1 of the embodiments of the present application has not only carrier transport structures with rich structural types, but also a plurality of carrier transport paths. The above structural features may improve the contact performance between the doped semiconductor layer 200 and the metal electrode 300, reduce the transport loss of carriers, and further improve the photoelectric conversion efficiency of the solar cell.

The conductive structure in the first conductive region 1a will be further described below.

A number ratio of the second conductive structure 12 to the first metal particles 111 is 1: 4000 to 1: 1. Exemplarily, the number ratio of the second conductive structure 12 to the first metal particles 111 is 1: 4000, 1: 3000, 1: 2000, 1: 1000, 1: 800, 1: 500, 1: 200, 1: 100, 1: 80, 1:50, 1:20, 1:10, or 1: 1.

When the number ratio of these two conductive structures is controlled within the above range, the open circuit voltage and the contact performance of the solar cell may be better balanced, and the occurrence of phenomena such as increasing damage to the doped semiconductor layer 200 or the silicon substrate 100 or increasing contact resistance can be reduced.

It is understood that the number ratio of the second conductive structure 12 to the first metal particles 111 can be calculated by measuring the number of the second conductive structure 12 and the number of the first metal particles 111 in any 10 µm × 10 µm region, respectively. Specifically, 10 µm × 10 µm regions at five different positions can be selected, the second conductive structure 12 and the first metal particles 111 can be counted and the number ratio of the second conductive structure 12 and the first metal particles 111 can be calculated, and the range between the minimum value and the maximum value of the number ratio at these different positions can reflect the number ratio range of the second conductive structure 12 and the first metal particles 111, and the average value of the number ratios at these different positions can reflect the average level of the number ratio of the second conductive structure 12 and the first metal particles 111.

Preferably, the number ratio of the second conductive structure 12 to the first metal particles 111 is 1: 1000 to 1:20.

In the first conductive structure 11, the particle size of the first metal particles 111 is 20 nm to 360 nm. Exemplarily, the particle size of the first metal particles 111 is 20 nm, 50 nm, 80 nm, 100 nm, 150 nm, 180 nm, 200 nm, 250 nm, 280 nm, 300 nm, 320 nm or 360 nm.

By controlling the particle size of the first metal particles 111 within the above range, it is possible to provide a reasonable growth space for the radial second conductive structure 12, and to make the second conductive structure 12 have a good emissive morphology, thereby improving the carrier transport capacity. The disadvantage of the growth of the second conductive structure 12 on the surface of the first metal particles 111 due to too small particle size, and making it difficult for the second conductive structure 12 to grow into a metal structure having obvious emission morphology characteristics may be avoided, and the occurrence of a situation where the second conductive structure 12 is hindered by too large particle size may be reduced.

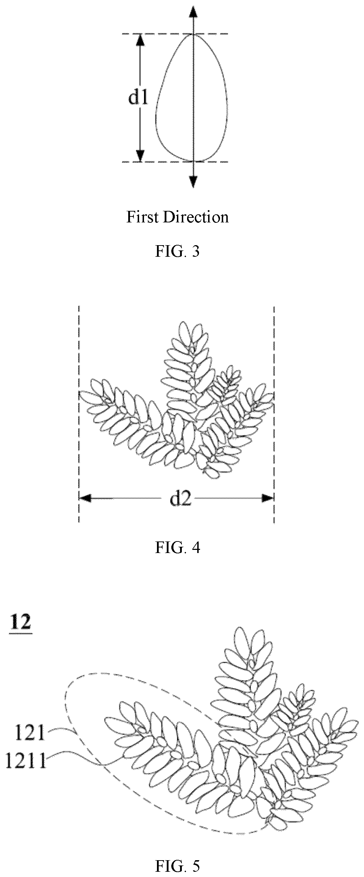

It should be noted that, the first metal particles 111 may have a spherical shape and/or an ellipsoid shape, and when the first metal particles 111 have a spherical shape, the size of the first metal particles 111 refers to the diameter of the spherical shape. When the first metal particles 111 have an ellipsoid shape, the particle size of the first metal particles 111 refers to the longest dimension of the ellipsoid. For example, as shown in FIG. 3, taking an irregular ellipsoid as an example, the ellipsoid has two farthest points along the first direction, and the linear distance d1 between these two points is the longest dimension of the ellipsoid, which is also the particle size of the ellipsoid.

Further, in any 10 µm × 10 µm region of the first conductive region 1a, the number of the first metal particles 111 is 200 to 4000, wherein the number of the first metal particles 111 having a particle size in a range of 100 nm to 360 nm is 100 to 1500, and the number of the first metal particles 111 having a particle size in a range of less than 100 nm is 100 to 2500.

Referring back to FIG. 2, the first conductive structure 11 includes second metal particles 112 attached to the surface of the first metal particles 111 in addition to the first metal particles 111 described above. The particle size of the second metal particles 112 is less than 20 nm, the number of the second metal particles 112 on one of the first metal particles 111 is 1 to 50, and the second metal particles 112 and the first metal particles 111 have the same metal element.

The adhesion of the second metal particles 112 having the above number and particle size to the first metal particles 111 may further increase the surface area of the first conductive structure 11, and then facilitate further optimization of the contact performance between the doped semiconductor layer 200 and the metal electrode 300 and reduction of the contact resistance between the doped semiconductor layer 200 and the metal electrode 300.

Further, a size of the second conductive structure 12 is 0.2 µm to 2 µm. Exemplarily, the size of the second conductive structure 12 is 0.2 µm, 0.5 µm, 0.8 µm, 1.0 µm, 1.2 µm, 1.5 µm, 1.8 µm, or 2 µm.

As shown in FIG. 4, the second conductive structure 12 is a radial structure, and the size of the second conductive structure 12 refers to the width d2 between the farthest two points where the second conductive structure 12 diverges and expands outward.

When the size of the second conductive structure 12 is within the above range, it is possible to have good carrier transport capability, reduce the damage range of the contact interface between the doped semiconductor layer 200 and the metal electrode 300, reduce the occurrence of contact recombination, and better optimize the contact performance between the doped semiconductor layer 200 and the metal electrode 300.

Further, in any 10 µm×10 µm region of the first conductive region 1a, the number of the second conductive structure 12 is 1 to 450, wherein the number of the second conductive structure 12 having a particle size in a range of 1 µm to 2 µm is 1 to 100, and the number of the second conductive structure 12 having a particle size in a range of less than 1 µm is 1 to 350.

As shown in FIG. 5, the second conductive structure 12 includes a plurality of stripe-shaped first sub-structures 121 diverging towards the metal electrode 300, and the number of the first sub-structures 121 is 2 to 20. Exemplarily, the number of first sub-structures 121 is 2, 5, 8, 10, 12, 15, 18, or 20. The number of first sub-structures 121 described above advantageously ensures that the second conductive structure 12 provides both a greater number of carrier transport paths and a reduced extent of interface damage resulting therefrom.

Any one of the first sub-structures 121 is composed of a plurality of second sub-structures 1211, any one of the second sub-structures 1211 is in a shape of wheat grain, and a plurality of the second sub-structures 1211 are combined together to form the first sub-structure 121 in a shape of wheat ears; wherein the second sub-structure 1211 has a cross-sectional dimension of 2 nm to 40 nm.

That is, in an embodiment of the present application, the second conductive structure 12 is formed by a plurality of first sub-structures 121 in the shape of wheat ears diverging towards the metal electrode 300, and any one of the first sub-structures 121 in the shape of wheat ears is formed by a combination of a plurality of second sub-structures 1211 in the shape of wheat grains. This particular divergent structure feature enables the second sub-structure 1211 to have a higher degree of divergence, providing larger area in contact with the metal electrode 300, which is beneficial to further enhance carrier transport capability.

Wherein the cross-sectional dimension of the second sub-structure 1211 is 2 nm to 40 nm, including any point value in the numerical range, for example, the cross-sectional dimension of the second sub-structure 1211 is 2 nm, 5 nm, 10 nm, 15 nm, 20 nm, 25 nm, 30 nm, 35 nm or 40 nm. In addition, the cross-sectional dimension of the second sub-structure 1211 refers to the corresponding cross-sectional width of the second sub-structure 1211 projected on a horizontal plane of the silicon substrate 100.

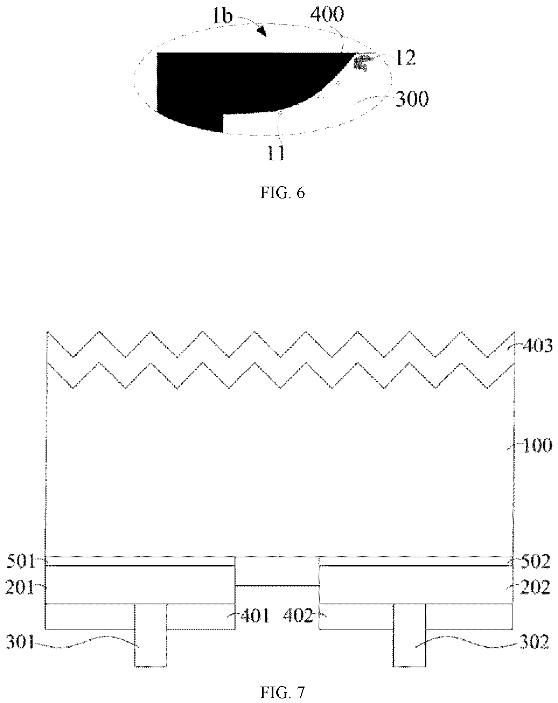

**In** addition to the first conductive region 1a, the metal-semiconductor contact structure 1 of the embodiments of the present application has a second conductive region 1b at the contact interface between the doped semiconductor layer 200 and the metal electrode 300, and the second conductive region 1b is located at the edge of the first conductive region 1a. As shown in conjunction with FIG. 2 and FIG. 6, the second conductive region 1b includes an unburned passivation layer 400, and the above-mentioned first conductive structure 11 and second conductive structure 12 are provided between the unburned passivation layer 400 and the metal electrode 300. Therein, the density of the first conductive structure 11 in the second conductive region 1b is lower than the density of the first conductive structure 11 in the first conductive region 1a, and the density of the second conductive structure 12 in the second conductive region 1b is lower than the density of the second conductive structure 12 in the first conductive region 1a.

In the metal-semiconductor contact structure 1 according to an embodiment of the present application, in addition to the first conductive region 1a having a stronger carrier transport ability in the middle region of the contact interface between the doped semiconductor layer 200 and the metal electrode 300, there is a second conductive region 1b at the edge of the first conductive region 1a. The second conductive region 1b is located at a position corresponding to the passivation layer 400 which is not burnt through, and the first conductive region 1a is located at a position mainly corresponding to the position where the passivation layer 400 is burnt through, so that the doped semiconductor layer 200 is in direct contact with the metal electrode 300. For example, taking the case where the metal electrode 300 is a sub-gate having a width of 20 µm to 35 µm, the first conductive region 1a is in a width range of 18 µm to 33 µm at the center of the gate line, and the second conductive region 1b is in a width range of 1 µm to 5 µm at the edge of the gate line.

In the second conductive region 1b, the passivation layer 400, which is not burnt through, can protect the doped semiconductor layer 200 on the inner side thereof, thereby serving as passivation protection, thereby further reducing the damage range of the surface of the doped semiconductor layer 200 and reducing contact recombination loss of carriers due to the damage of the surface structure of the doped semiconductor layer 200. That is to say, the conductive structure in the first conductive region 1a located in the middle has a greater density, the distribution thereof is more concentrated, and thus plays a dominant role in the carrier transport process. At the same time, although the density of the conductive structure in the second conductive region 1b is relatively small, the passivation layer 400 which has not been burnt through in this region can play the role of passivation protection, thus enabling the metal-semiconductor contact structure 1 of the present application to not only improve the carrier transport capacity through the optimization of the conductive structure, but also reduce the carrier recombination loss by reducing the range of the interface area where the doped semiconductor layer 200 is damaged by ablation, so as to promote the improvement of the contact performance between the doped semiconductor layer 200 and the metal electrode 300 from two aspects, which is finally reflected in the effective improvement of the photoelectric conversion efficiency of the solar cell.

Further details of the metal-semiconductor contact structure 1 will be described further below.

In an embodiment of the present application, the doped semiconductor layer 200 includes one of a doped polycrystalline silicon layer, a doped microcrystalline silicon layer or a doped crystalline silicon layer. For example, where the doped semiconductor layer 200 includes a doped crystalline silicon layer, the doped crystalline silicon layer may be prepared by thermal diffusion of a doping element on crystalline silicon. As another example, where the doped semiconductor layer 200 includes a doped polysilicon layer, the doped semiconductor layer 200 may be a doped polysilicon layer doped with a doping element by an LPCVD or PECVD process.

The doping element in the doped semiconductor layer 200 is an N-type doping element or a P-type doping element. Wherein the N-type doping element includes at least one of a phosphorus element, an antimony element, or an arsenic element, and the P-type doping element includes at least one of a boron element, an indium element, or a gallium element. Exemplarily, the doped semiconductor layer 200 is a phosphorus-doped semiconductor layer 200, which means that when the main component is a polycrystalline silicon layer, a phosphorus element may be doped therein to improve the carrier transport ability, and on this basis, a certain concentration of other kinds of doping elements may also be doped into the phosphorus-doped semiconductor layer 200, which is not limited in the present application.

**In** an embodiment of the present application, the metal electrode 300 takes a material corresponding to the metal element as a main component, and may also include an appropriate amount of impurities. The metal electrode 300, the first metal particles 111, and the second conductive structure 12 all have the same metal element. For example, the metal electrode 300 is a silver electrode, the main component of the silver electrode is elemental silver, but the silver electrode may also include a small amount of metallic aluminum impurities (for example, the content of metallic aluminum impurities is less than or equal to 0.1wt%).

In addition, the semiconductor layer 200 may be provided on a light-receiving surface and/or a backlight surface of the silicon substrate 100, and correspondingly, the metal-semiconductor contact structure 1 may also be provided on the light-receiving surface and/or the backlight surface of the silicon substrate 100. In addition, the metal-semiconductor contact structure 1 is preferably provided on a relatively flat surface, such as the surface of a polished silicon substrate 100.

Referring back to the solar cell shown in FIG. 1, the metal-semiconductor contact structure 1 is provided on the backlight surface of the silicon substrate 100 as an example for further explanation. In an alternative implementation, the silicon substrate 100 is an N-type silicon substrate 100, a doped semiconductor layer 200, specifically an N-type doped polycrystalline silicon layer, formed by a process such as LPCVD or PECVD is provided on the backlight surface of the silicon substrate 100, and a metal electrode 300 is provided on the N-type doped polycrystalline silicon layer in contact with each other. The N-type doped polycrystalline silicon layer and the metal electrode 300 form the above-mentioned metal-semiconductor contact structure 1. It should be understood that the silicon substrate 100 may also be a P-type silicon substrate 100, and the conductivity type of the doped semiconductor layer 200 may be the same as or different from that of the silicon substrate 100, and the present application does not limit the above-mentioned conductivity type.

In addition to the metal-semiconductor contact structure 1 described above, the solar cell may also have other functional layers. Exemplarily, the backlight surface of the solar cell may also include:
a dielectric layer 500, which is provided on the back light surface of the silicon substrate 100 and is located between the silicon substrate 100 and the doped semiconductor layer 200, wherein the dielectric layer 500 and the doped semiconductor layer 200 constitute a passivation contact structure, so as to improve the carrier transport ability and at the same time optimize the passivation performance;
a passivation layer 400 provided on the side of the doped semiconductor layer 200 facing away from the silicon substrate 100 for improving the passivation performance.

In the metal-semiconductor contact structure 1, the metal electrode 300 is in contact with the doped semiconductor layer 200 after passing through the passivation layer 400, and forms the first conductive structure 11 and the second conductive structure 12 in the first conductive region 1a. However, a small part of the passivation layer 400 is also not completely burnt through at the edge of the metal electrode 300, and this part of the passivation layer 400 and the metal electrode 300 as previously described form the second conductive region 1b.

The light-receiving surface of the solar cell may further include: a P-type diffusion layer 600, which is provided on the light-receiving surface of the silicon substrate 100 and may be formed by a thermal diffusion process, and is used for forming a PN junction with the silicon substrate 100; a passivating anti-reflection layer 700, which is provided on the side of the P-type diffusion layer 600 facing away from the silicon substrate 100, and is used for performing passivation and anti-reflection functions; a light-receiving surface metal electrode 800, which passes through the passivating anti-reflection layer 700 and is in ohmic contact with the P-type diffusion layer 600.

The manufacturing process of the above-mentioned solar cell will be explained.

With regard to the film layers such as the silicon substrate 100 and the doped semiconductor layer 200 and the passivation layer 400, a semi-finished product of the above-mentioned solar cell can be obtained by conventional processes such as texturing, thermal diffusion, chain cleaning, polishing, PECVD, RCA cleaning and ALD coating. For example, a P-type diffusion layer 600 is formed on the light-receiving surface of the silicon substrate 100 by thermal diffusion (specifically, a process such as boron diffusion), unnecessary film layers such as a winding plating layer and an oxide layer are removed by operations such as chain cleaning and polishing, and the backlight surface of the silicon substrate 100 is made smoother; then a dielectric layer 500 and an N-type doped polycrystalline silicon layer are successively formed on the backlight surface of the silicon substrate 100 by a PECVD process; after the unnecessary film layers such as a winding plating layer are removed by RCA cleaning, a passivation layer 400 is formed on the N-type doped polycrystalline silicon layer by an ALD process; and a passivating anti-reflection layer 700 is formed on the P-type diffusion layer 600, thereby obtaining a semi-finished product of the solar cell. Wherein the N-type doped polysilicon layer is the doped semiconductor layer 200.

An electrode paste is printed and sintered on the semi-finished product of the solar cell, and then a laser-induced contact treatment is performed, so that the doped semiconductor layer 200 and the metal electrode 300 form the metal-semiconductor contact structure 1 as described above. The specific method is as follows:
printing an electrode paste on the passivation layer 400 on the doped semiconductor layer 200; wherein the electrode paste includes a glass phase material, a metal material and an organic carrier, and the metal material has the above-mentioned metal element therein;
pre-sintering the electrode paste to form an electrode precursor;
performing a laser-induced contact treatment from the side of the silicon substrate 100 facing away from the electrode precursor (i.e. the light-receiving surface side of the silicon substrate 100), so that the electrode precursor forms a metal electrode 300, and the metal electrode 300 and the doped semiconductor layer 200 form a metal-semiconductor contact structure 1.

By printing and sintering the electrode paste on the passivation layer 400 on the back light surface of the silicon substrate 100, and in cooperation with performing the laser-induced contact treatment on the light-receiving surface of the silicon substrate 100, after the laser energy passing through the silicon substrate 100 to the back light surface side, the metal-semiconductor contact structure 1 having the above-mentioned structural features may be formed.

Furthermore, in the step of pre-sintering the electrode paste, the total sintering time is 40 s to 100 s, and the sintering time corresponding to a condition of the sintering temperature of 700°C to 800°C is 0.5 s to 8 s. Compared with the high-temperature pre-sintering operation in the related art, the embodiments of the present application do not cause large-area corrosion to the surface of the doped silicon-based semiconductor layer in spite of such a high-temperature pre-sintering condition.

Further, in the step of performing the laser-induced contact treatment from the side of the silicon substrate 100 facing away from the electrode precursor, a voltage of the reverse bias voltage is 8 V to 14 V The heat generated by the carriers generated by the laser-induced contact treatment when passing through the contact interface between the first doped silicon-based semiconductor layer and the electrode precursor is closely related to the aforementioned range of the reverse bias voltage. When the reverse bias voltage is within the aforementioned range, it is conducive to generating a higher heat as the carriers pass through the contact interface, and this higher heat is used to decompose the glass phase material at the corresponding positions, so as to provide a space for the growth and formation of the first conductive structure 11 and the second conductive structure 12.

Further, in the step of performing the laser-induced contact treatment, conditions of the laser-induced contact treatment include a single wavelength spectrum having a wavelength of 500 nm to 1100 nm, a current density of 800 A/cm² to 1300 A/cm², and a scanning rate of 32 m/s to 50 m/s.

For the aforementioned laser-induced contact treatment conditions, a laser of a single wavelength is used to excite photogenerated carriers in the doped semiconductor layer 200. Exemplarily, the wavelength of the injected laser light in the process of the laser-induced contact treatment is 532 m, 635 nm, 650 nm, 808 nm, 980 nm, or 1064 nm. When the semiconductor element of the doped semiconductor layer 200 is silicon and a laser is used for laser-induced contact treatment, it is preferable to use a laser with a wavelength of 1064 nm or 808 nm.

Preferably, the preparation method of the metal-semiconductor contact structure 1 further includes: performing light injection after the step of pre-sintering the electrode paste and before the step of performing the laser-induced contact treatment on the side of the silicon substrate 100 facing away from the electrode precursor. The light injection process is mainly to improve the passivation performance. Process steps of light injection annealing furnace include: a first step of heating, activating H atoms in the silicon nitride passivation film by the heating; a second step of controlling the valence state of H atoms by illumination, so that the H atoms combine with recombination center (defect) at P+ emitter and N-type substrate to form non-recombination center. Finally, a good passivation effect is achieved, and the purpose of improving the open circuit voltage and filling factor is achieved.

In addition, compared with a method of performing the light injection after the step of performing the laser-induced contact treatment, a method of firstly pre-sintering the electrode paste at high-temperature, then performing light injection, and then performing the laser-induced contact treatment on the electrode precursor is more advantageous to optimize the performance of the solar cell. This is because the operation of light injection also generates a certain amount of heat, and when light injection is performed before performing laser-induced contact treatment, it is possible to passivate grain boundaries and defect states.

Further, the light injection process adjusts the Fermi level change by temperature and light intensity, and controls the total amount of hydrogen and valence state to improve the passivation performance. Further, the step of light injection includes: primarily heating of the electrode precursor, wherein a peak temperature of the primary heating is between 180°C to 620°C; secondary heating of the electrode precursor and illumination, wherein a peak temperature of the secondary heating is 80°C to 320°C, an energy density of the illumination is 12 kW/m² to 120 kW/m², and the wavelength of the illumination is a continuous spectral band of 500 nm to 1100 nm. By controlling the heating conditions and the illumination conditions in the above-mentioned range in the light injection step, not only a good passivation effect may be achieved, but also the glass phase material corroding the first doped silicon-based semiconductor layer due to an excessively high heating temperature may be prevented. It should be noted that in the light injection step of the embodiment of the present application, a continuous spectral band having a wavelength of 500 nm to 1100 nm is injected, which is different from the single-wavelength laser used in the laser-induced contact treatment step.

It should be noted that the above-mentioned solar cell preparation process is merely an alternative implementation, and the metal-semiconductor contact structure 1 in the embodiments of the present application may also be obtained by other process techniques in the art, and is not limited in the present application.

The metal-semiconductor contact structure 1 described above is also suitable for use in other types of solar cells. Therefore, referring to FIG. 7, the embodiments of the present application provide a second type solar cell, the solar cell is an IBC solar cell and the solar cell includes:
a silicon substrate 100;
a first dielectric layer 501, a first doped semiconductor layer 201 and a first passivation layer 401 which are successively provided in an N-type conductive region of a backlight surface of the silicon substrate 100, and a second dielectric layer 502, a second doped semiconductor layer 202 and a second passivation layer 402 which are successively provided in a P-type conductive region of the backlight surface of the silicon substrate 100, wherein the first doped semiconductor layer 201 is doped with an N-type doping element, and the second doped semiconductor layer 202 is doped with a P-type doping element;
a first metal electrode 301 penetrating the first passivation layer 401 of the N-type conductive region and being in ohmic contact with the first doped semiconductor layer 201, so that the first metal electrode 301 and the first doped semiconductor layer 201 form a first metal-semiconductor contact structure 1;
a second metal electrode 302 penetrating the second passivation layer 402 of the P-type conductive region and being in ohmic contact with the second doped semiconductor layer 202, so that the second metal electrode 302 and the second doped semiconductor layer 202 form a second metal-semiconductor contact structure 1.

That is, in the second type solar cell, the doped semiconductor layer 200 includes a first doped semiconductor layer 201 and a second doped semiconductor layer 202 having different conductivity types, and the metal electrode 300 includes a first metal electrode 301 and a second metal electrode 302 which are in contact with the first doped semiconductor layer 201 and the second doped semiconductor layer 202, respectively, to form the metal-semiconductor contact structure 1 as described above, respectively.

The silicon substrate 100 has an N-type conductivity or a P-type conductivity, for example, the silicon substrate 100 is an N-type silicon substrate 100. A light-receiving surface of the silicon substrate 100 has a textured surface structure such as a pyramid-shaped textured surface structure. By providing the textured surface structure, it is advantageous to reduce the reflectivity of the surface of the silicon substrate 100 and increase the light trapping effect of the light inside the silicon substrate 100. In addition, other structural film layers may be provided on the light-receiving surface of the silicon substrate 100 according to actual needs. For example, a third passivation layer 403 is provided on the light-receiving surface of the silicon substrate 100.

The embodiments of the present application further provide a photovoltaic module including: the solar cell according to the first aspect and a packaging structure, wherein several solar cells are connected in series and/or in parallel to obtain a solar cell string, and the solar cell string is packaged in the packaging structure to form the above-mentioned photovoltaic module.

The present application will be further described below with reference to more specific examples.

### Embodiment 1

The present embodiment provides a solar cell including:
an N-type silicon substrate;
a P-type diffusion layer, a passivating anti-reflection layer and a metal electrode of the light-receiving surface successively provided on the light-receiving surface of the N-type silicon substrate, and the metal electrode of the light-receiving surface passing through the passivating anti-reflection layer and is in ohmic contact with the P-type diffusion layer;
a dielectric layer, an N-type doped polysilicon layer, a passivation layer and a metal electrode of the backlight surface successively provided on the backlight surface of the N-type silicon substrate, and the metal electrode of the backlight surface passing through the passivation layer and is in contact with the N-type doped polysilicon layer.

A first conductive region is provided at the contact interface between the N-type doped polycrystalline silicon layer and the metal electrode of the back light surface, and the first conductive region has:
a first conductive structure, the first conductive structure including a plurality of first metal particles distributed in the first conductive region, the first metal particles having a spherical and/or ellipsoidal shape, at least part of the first conductive structure contacting the doped semiconductor layer;
a second conductive structure 12, wherein the second conductive structure 12 is radial, at least part of the second conductive structure 12 is located on a surface of the first metal particles, and a radial direction of the second conductive structure 12 is a direction towards the metal electrode;
wherein the metal electrode, the first metal particles, and the second conductive structure all have the same silver element.

Wherein the particle size of the first metal particles is 20 nm to 360 nm, the particle size of the second metal particles is less than 20 nm, the size of the second conductive structure is 0.2 µm to 2 µm, and the number ratio of the second conductive structure to the first metal particles is 1: 4000. In this embodiment, the ratio of the number of the second conductive structure to the number of the first metal particles may be obtained by measuring the number of the corresponding structures in the first conductive region at various positions of any 10 µm×10 µm region and calculating the number of the corresponding structures and then averaging them.

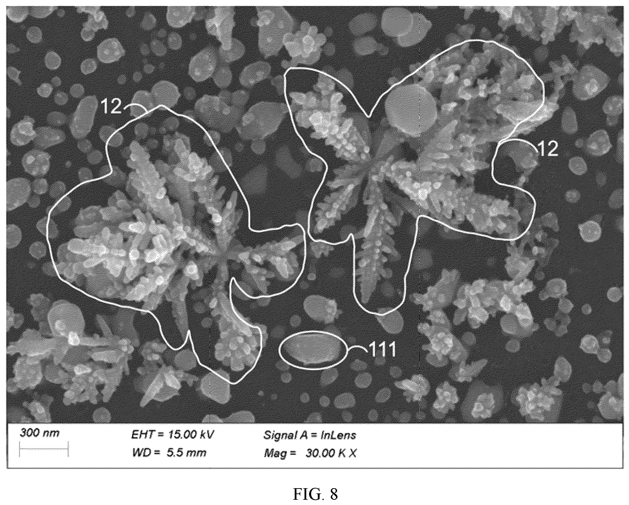

Scanning electron microscopy (SEM) test was performed on the metal-semiconductor contact structure described above. See FIG. 8 for SEM image. The scanning electron microscopy test method for the metal-semiconductor contact structure is described below:
using a chemical etching means, first heating a nitric acid solution with a mass fraction of 50% to 80% to 60°C to 85°C then immersing the solar cell in the above-mentioned nitric acid solution for 3 to 10 minutes, and removing the metal electrode; using deionized water or distilled water to flush out the residual liquid medicine; then immersing the cleaned solar cell in a hydrofluoric acid solution with a mass fraction of 1% to 10% for 2 to 5 minutes to remove the residual glass phase material; finally, using deionized water or distilled water to flush out the residual liquid and completing corrosion. The conductive structures of the first conductive region and the second conductive region in the metal-semiconductor contact structure were exposed, and were photographed by a scanning electron microscope to obtain corresponding SEM diagrams. It is to be understood that the concentration of the acid agent, the etching temperature and time used in the above-mentioned etching means may be adjusted adaptively according to the removal effect, as long as the metal electrode can be removed and the glass phase material can be removed. For example, as the concentration of the acid agent is increased and/or the temperature is increased, the etching time may be shortened as appropriate to achieve better removal of the metal electrode and removal of the glass phase material.

### Embodiments 2 to 7

These embodiments were the same as Embodiment 1, except that the number ratio of the second conductive structure and the first metal particles are as shown in Table 1.

### Description of performance testing:

Open circuit voltage, filling factor, photoelectric conversion efficiency test:
The open circuit voltage, filling factor, photoelectric conversion efficiency and other performance tests were carried out using a Halm test and separation equipment. The halm machine was a solar simulator equipped with electronic load, data acquisition and calculation equipment to test the electrical performance of photovoltaic devices (including solar cells). The silicon wafer of the tested solar cell was controlled to size 182 and the calibrated light intensity was 1000±5 W/m².

Contact resistance test: A contact resistivity tester (e.g. TLM-STD of American Photovoltaic) was used for the contact resistance performance test, and the characteristic impedance of the transmission line is determined by measuring the current and voltage, and then the value of the contact resistance was derived by a calculation formula according to the characteristic impedance. The width of the test specimen was 6 mm.

**Table 1 Number ratio of conductive structures and battery performance test results of the embodiments**

| | Number ratio (Second conductive structure/First metal particles | Photoelectric conversion efficiency(%) | Open circuit voltage(V) | Filling factor (%) | Series resistance(mΩ*cm²) |
|---|---|---|---|---|---|
| Embodiment 1 | 1:4000 | 24.939 | 0.7293 | 82.40 | 1.12 |
| Embodiment 2 | 1:500 | 25.114 | 0.7290 | 82.91 | 1.07 |
| Embodiment 3 | 1:100 | 25.095 | 0.7289 | 82.96 | 1.08 |
| Embodiment 4 | 1:25 | 25.114 | 0.7296 | 82.95 | 1.05 |
| Embodiment 5 | 1:1 | 25.061 | 0.7287 | 82.88 | 1.05 |
| Embodiment 6 | 1:10000 | 24.894 | 0.7306 | 82.11 | 1.22 |
| Embodiment 7 | 2:1 | 24.809 | 0.7208 | 82.93 | 1.01 |

It can be seen from the test results in Table 1 that in the solar cells of Embodiment 1 to Embodiment 5 of the present application, the series resistance decreases to about 1.00 mΩ·cm², and the photoelectric conversion efficiency reaches about 25.1%. It can be seen that the solar cells of Embodiment 1 to Embodiment 5 of the present application all have excellent open circuit voltage and series resistance performance, and have a relatively high photoelectric conversion efficiency. It can be seen therefrom that 1: 4000 to 1: 1 is a preferred range for the number ratio of the second conductive structure to the first metal particles.

Further comparing Embodiment 6 to Embodiment 7, it can be seen that when the number ratio of the second conductive structure to the first metal particles is out of the range of 1: 4000 to 1: 1, the cell performance is slightly inferior to that of the preferred embodiment; when the number ratio is less than the optimal range, the series resistance increases and the filling factor decreases, which results in a slight decrease of the photoelectric conversion efficiency. When the number ratio is larger than the optimal range, the open circuit voltage decreases and the photoelectric conversion efficiency decreases due to the more serious corrosion of the metal electrode to the substrate.

The technical solutions disclosed in the embodiments of the present application are described in detail above. Specific examples are used herein to illustrate the principle and implementations of the present application. The descriptions of the above embodiments are only used to help understand the technical solution of the present application and core ideas thereof. Moreover, for those of ordinary skill in the art, according to the ideas of the present application, there will be changes in the specific implementations and the scope of application. In summary, the content of this specification should not be construed as limiting the present application.

## Claims

1. A metal-semiconductor contact structure, comprising:
a doped semiconductor layer;
a metal electrode in contact with the doped semiconductor layer; and
a first conductive region provided at a contact interface between the doped semiconductor layer and the metal electrode, wherein the first conductive region has:
a first conductive structure, the first conductive structure comprising a plurality of first metal particles distributed in the first conductive region, the first metal particles having a spherical and/or ellipsoidal shape, at least part of the first conductive structure contacting the doped semiconductor layer;
a second conductive structure, wherein the second conductive structure is radial, at least part of the second conductive structure is located on a surface of the first metal particles, and a radial direction of the second conductive structure is a direction towards the metal electrode,
wherein the metal electrode, the first metal particles, and the second conductive structure all have a same metal element; and a number ratio of the second conductive structure to the first metal particles is 1: 4000 to 1: 1.

2. The metal-semiconductor contact structure according to claim 1, wherein the number ratio of the second conductive structure to the first metal particles is 1: 1000 to 1: 20.

3. The metal-semiconductor contact structure according to claim 1, wherein a particle size of the first metal particles is 20 nm to 360 nm.

4. The metal-semiconductor contact structure according to claim 1, wherein in any 10 µm×10 µm region of the first conductive region, the number of the first metal particles is 200 to 4000, wherein the number of the first metal particles having a particle size in a range of 100 nm to 360 nm is 100 to 1500, and the number of the first metal particles having a particle size in a range of less than 100 nm is 100 to 2500.

5. The metal-semiconductor contact structure according to claim 1, wherein the first conductive structure further includes second metal particles attached to a surface of the first metal particles, the first metal particles having a particle size of 20 nm to 360 nm, the second metal particles having a particle size of less than 20 nm, the number of the second metal particles on one of the first metal particles being 1 to 50, and the second metal particles having the same metal element as the first metal particles.

6. The metal-semiconductor contact structure according to claim 1, wherein a size of the second conductive structure is 0.2 µm to 2 µm.

7. The metal-semiconductor contact structure according to claim 1, wherein in any 10 µm×10 µm region of the first conductive region, the number of the second conductive structure is 1 to 450, wherein the number of the second conductive structure having a particle size in a range of 1 µm to 2 µm is 1 to 100, and the number of the second conductive structure having a particle size in a range of less than 1 µm is 1 to 350.

8. The metal-semiconductor contact structure according to claim 1, wherein the second conductive structure comprises a plurality of stripe-shaped first sub-structures diverging towards the metal electrode, and the number of the first sub-structures is 2 to 20.

9. The metal-semiconductor contact structure according to claim 8, wherein any one of the first sub-structures is composed of a plurality of second sub-structures, any one of the second sub-structures is in a shape of wheat grain, and a plurality of the second sub-structures are combined together to form the first sub-structure in a shape of wheat ears;
wherein the second sub-structure has a cross-sectional dimension of 2 nm to 40 nm.

10. The metal-semiconductor contact structure according to any one of claims 1 to 9, wherein:
a second conductive region is further provided at a contact interface between the doped semiconductor layer and the metal electrode, the second conductive region is located at an edge of the first conductive region, and the second conductive region comprises an unburned passivation layer, the first conductive structure and/or the second conductive structure is provided between the unburned passivation layer and the metal electrode; and
when the second conductive region comprises the first conductive structure, a density of the first conductive structure in the second conductive region is lower than a density of the first conductive structure in the first conductive region; when the second conductive region comprises the second conductive structure, a density of the second conductive structure in the second conductive region is lower than a density of the second conductive structure in the first conductive region.

11. The metal-semiconductor contact structure according to any one of claims 1 to 9, wherein:
the doped semiconductor layer comprises one of a doped amorphous silicon layer, a doped polycrystalline silicon layer, a doped microcrystalline silicon layer or a doped crystalline silicon layer; and/or,
a doping element in the doped semiconductor layer is an N-type conductive element or a P-type conductive element; and/or,
the metal element comprises silver element; and/or,
at least a portion of the second conductive structure is located on a surface facing the metal electrode of the doped semiconductor layer.

12. A solar cell, wherein the solar cell comprises:
a silicon substrate;
a doped semiconductor layer, wherein the doped semiconductor layer is provided on the silicon substrate;
a metal electrode in contact with the doped semiconductor layer; and
a first conductive region provided at a contact interface between the doped semiconductor layer and the metal electrode, wherein the first conductive region has:
a first conductive structure, the first conductive structure comprising a plurality of first metal particles distributed in the first conductive region, the first metal particles having a spherical and/or ellipsoidal shape, at least part of the first conductive structure contacting the doped semiconductor layer;
a second conductive structure, wherein the second conductive structure is radial, at least part of the second conductive structure is located on a surface of the first metal particles, and a radial direction of the second conductive structure is a direction towards the metal electrode,
wherein the metal electrode, the first metal particles, and the second conductive structure all have a same metal element.

13. The solar cell according to claim 12, wherein a number ratio of the second conductive structure to the first metal particles is 1: 4000 to 1: 1.

14. The solar cell according to claim 12, wherein, the number ratio of the second conductive structure to the first metal particles is 1: 1000 to 1: 20; and/or,
a particle size of the first metal particles is 20 nm to 360 nm; and/or,
in any 10 µm × 10 µm region of the first conductive region, the number of the first metal particles is 200 to 4000, wherein the number of the first metal particles having a particle size in a range of 100 nm to 360 nm is 100 to 1500, and the number of the first metal particles having a particle size in a range of less than 100 nm is 100 to 2500; and/or,
the first conductive structure further comprises second metal particles attached to a surface of the first metal particles, the first metal particles having a particle size of 20 nm to 360 nm, the second metal particles having a particle size of less than 20 nm, the number of the second metal particles on one of the first metal particles being 1 to 50, and the second metal particles having the same metal element as the first metal particles; and/or,
a size of the second conductive structure is 0.2 µm to 2 µm; and/or,
in any 10 µm × 10 µm region of the first conductive region, the number of the second conductive structure is 1 to 450, wherein the number of the second conductive structure having a particle size in a range of 1 µm to 2 µm is 1 to 100, and the number of the second conductive structure having a particle size in a range of less than 1 µm is 1 to 350; and/or,
the second conductive structure comprises a plurality of stripe-shaped first sub-structures diverging towards the metal electrode, and the number of the first sub-structures is 2 to 20; and/or,
any one of the first sub-structures is composed of a plurality of second sub-structures, any one of the second sub-structures is in a shape of wheat grain, and a plurality of the second sub-structures are combined together to form the first sub-structure in a shape of wheat ears; wherein the second sub-structure has a cross-sectional dimension of 2 nm to 40 nm; and/or,
a second conductive region is further provided at a contact interface between the doped semiconductor layer and the metal electrode, the second conductive region is located at an edge of the first conductive region, and the second conductive region comprises an unburned passivation layer, the first conductive structure and/or the second conductive structure is provided between the unburned passivation layer and the metal electrode, wherein: when the second conductive region comprises the first conductive structure, a density of the first conductive structure in the second conductive region is lower than a density of the first conductive structure in the first conductive region; and when the second conductive region comprises the second conductive structure, a density of the second conductive structure in the second conductive region is lower than a density of the second conductive structure in the first conductive region.

15. The solar cell according to claim 12, wherein:
the solar cell further comprises: a dielectric layer provided between the silicon substrate and the doped semiconductor layer; and/or,
the solar cell further comprises a passivation layer provided on a side of the doped semiconductor layer facing away from the silicon substrate.

16. The solar cell according to claim 12, wherein the doped semiconductor layer comprises an N-type doped semiconductor layer and a P-type doped semiconductor layer, the N-type doped semiconductor layer and the P-type doped semiconductor layer are arranged in an interdigitated arrangement on a backlight surface of the silicon substrate, and an isolation region is provided between the N-type doped semiconductor layer and the P-type doped semiconductor layer; and
the metal electrode comprises a first metal electrode and a second metal electrode, the first metal electrode and the N-doped semiconductor layer being in contact with each other, and the second metal electrode and the P-doped semiconductor layer being in contact with each other.

17. A photovoltaic module, wherein the photovoltaic module comprises:
the solar cell according to any one of claims 12 to 16, several of the solar cells connected in series and/or in parallel to obtain a solar cell string; and
a packaging structure, wherein the solar cell string is packaged in the packaging structure.
